# EUROPEAN PATENT SPECIFICATION

(11) **EP 4 274 397 B1**
(45) Date of publication and mention of the grant of the patent: **02.07.2025**
(21) Application number: 22820447.5
(22) Date of filing: 26.05.2022
(51) Int. Cl.: H05K 7/20, H04R 1/28, H05K 5/06, G02B 27/01, G02C 5/14, G02C 11/06, G02C 11/00

(54) **ELECTRONIC DEVICE COMPRISING HEAT DISSIPATION STRUCTURE**
ELEKTRONISCHE VORRICHTUNG MIT WÄRMEABLEITUNGSSTRUKTUR
DISPOSITIF ÉLECTRONIQUE COMPRENANT UNE STRUCTURE DE DISSIPATION DE CHALEUR

(30) Priority: 09.06.2021 KR 20210075008
(43) Date of publication of application: 08.11.2023
(73) Proprietor: Samsung Electronics Co., Ltd., Suwon-si, Gyeonggi-do 16677 (KR)
(72) Inventor: UHM, Junwhon, Suwon-si Gyeonggi-do 16677 (KR); JO, Nammin, Suwon-si Gyeonggi-do 16677 (KR); LEE, Byounghee, Suwon-si Gyeonggi-do 16677 (KR)
(74) Representative: Nederlandsch Octrooibureau
(86) International application number: PCT/KR2022/007490
(87) International publication number: WO 2022/260319

(56) References cited:
- WO-A1-2020/242016
- CN-A- 107 065 228
- CN-A- 107 065 228
- CN-A- 112 099 231
- CN-A- 112 099 231
- CN-A- 112 255 803
- CN-U- 212 009 160
- KR-A- 20210 046 058
- US-A1- 2019 320 258

## Description

### [Technical Field]

The disclosure relates to an electronic device including a heat radiating structure.

### [Background Art]

As communication technology develops, wearable electronic devices can be miniaturized and lightened to the extent that they can be used without discomfort even when worn on a user's body. For example, the wearable electronic device such as a head-mounted device (HMD), a glasses-type device, a contact lens-type device, a ring-type device, and a smart watch (or band) are being provided. Since the wearable electronic device is directly worn on the body, portability and user accessibility can be improved.

CN112255803A discloses a HMD comprising a temple, a speaker and a PCB disposed in the temple, a rib comprised in the temple and a accommodating the printed circuit board, wherein a rear surface of the speaker is disposed to face a resonance space formed in the temple, and is connected to at least one hole formed in at least one region of the rib, the at least one hole connecting the resonance space to an outside of the temple.

WO2020/242016A1 discloses a HMD comprising a temple, a speaker and a PCB disposed in the temple, wherein a rear surface of the speaker is disposed to face a resonance space formed in the temple, and the resonance space comprises a space in which the printed circuit board is disposed, and is connected to at least one ventilation hole, the at least one ventilation hole connecting the resonance space to an outside of the temple.

### [Disclosure of Invention]

### [Technical Problem]

To provide various multimedia through the wearable electronic device, the wearable electronic device can include various output devices such as a display or a speaker, and electronic components. When the wearable electronic device is provided with a speaker, a relatively large mounting space is required, because a damping hole must be disposed in the speaker or a resonance space must be secured around the speaker in order to ensure the performance of a sound signal output through the speaker at a sound pressure (unit: dB) of the entire range.

Also, the wearable electronic device requires a heat radiating structure for radiating a heat generated from an electronic component such as an application processor (AP) or a power management integrated circuit (PMIC).

However, a space for securing the heat radiating structure for the wearable electronic device requiring portability and miniaturization, and a space for mounting various components such as the speaker are inevitably limited. Accordingly, there is a problem in that the effect of radiating a heat generated in the wearable electronic device is restrictive, and when a low band frequency signal is output through the speaker, a performance improvement of the speaker is also restrictive.

### [Solution to Problem]

An electronic device of various embodiments of the present disclosure includes a display member including at least one glass, a frame supporting at least a portion of the display member, and a leg member coupled to at least one side of the frame. The leg member includes a first structure, a second structure coupled with the first structure, a speaker disposed in a space formed between the first structure and the second structure, a printed circuit board disposed in the space formed between the first structure and the second structure, and a rib included in at least one of the first structure or the second structure and accommodating the printed circuit board. A rear surface of the speaker is disposed to face a resonance space formed between the first structure and the second structure, and the resonance space includes a space in which the printed circuit board is disposed, and is connected to at least one ventilation hole formed in at least one region of the rib, the at least one ventilation hole connecting the resonance space to an outside of the leg member.

An electronic device of various embodiments of the disclosure that are not covered by the subject-matter of the claims may include a display member including at least one glass, a frame supporting at least a portion of the display member, and a leg member coupled to at least one side of the frame. The leg member may include a housing, a speaker disposed in a space formed inside the housing, a printed circuit board disposed in the space formed inside the housing, and a rib configured to accommodate the printed circuit board in at least one region of the housing. A rear surface of the speaker may be disposed to face a resonance space formed inside the housing, and the resonance space may include a space in which the printed circuit board is disposed, and may be connected to at least one ventilation hole formed in at least one region of the rib, the at least one ventilation hole connecting the resonance space to an outside of the leg member.

### [Advantageous Effects of Invention]

According to an embodiment of the disclosure, when a speaker is installed in an electronic device, sound signals of various sound ranges may be output even though the volume of the electronic device is not increased.

According to an embodiment of the disclosure, a heat generated within the electronic device may be smoothly diffused outside while the bass performance of the speaker may be improved, by forming a resonance space connected to a rear surface of the speaker and a hole within the electronic device.

In addition, various effects directly or indirectly identified through the present document may be provided.

### [Brief Description of Drawings]

FIG. 1 is a diagram illustrating an electronic device according to an embodiment.
FIG. 2 illustrates one region of a leg member of an electronic device according to an embodiment.
FIG. 3 illustrates a structure forming a leg member of an electronic device according to an embodiment.
FIG. 4 illustrates one region of a leg member of an electronic device according to an embodiment.
FIG. 5 is a cross-sectional view taken along line A-A' of the leg member of FIG. 4 according to an embodiment.
FIG. 6 illustrates a heat radiating member included in a leg member of an electronic device according to an embodiment.
FIGS. 7A and 7B is a diagram illustrating a heat radiating path dependent on the provision of a sound pressure of a speaker included in a leg member of an electronic device according to various embodiment.
FIG. 8 is a flowchart for controlling a speaker according to a temperature of an electronic device according to an embodiment.
FIG. 9 is a block diagram of an electronic device in a network environment according to an embodiment.

Throughout the drawings, it should be noted that like reference numbers are used to depict the same or similar elements, features, and structures.

### [Mode for Carrying out the Invention]

The following description with reference to the accompanying drawings is provided to assist in a comprehensive understanding of various embodiments of the disclosure as defined by the claims. It includes various specific details to assist in that understanding but these are to be regarded as merely exemplary. Accordingly, those of ordinary skill in the art will recognize that various changes and modifications of the various embodiments described herein can be made without departing from the scope of the disclosure, which is defined by the appended claims. In addition, descriptions of well-known functions and constructions may be omitted for clarity and conciseness.

The terms and words used in the following description and claims are not limited to the bibliographical meanings, but, are merely used by the inventor to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims.

It is to be understood that the singular forms "a," "an," and "the" include plural referents unless the context clearly dictates otherwise. Thus, for example, reference to "a component surface" includes reference to one or more of such surfaces.

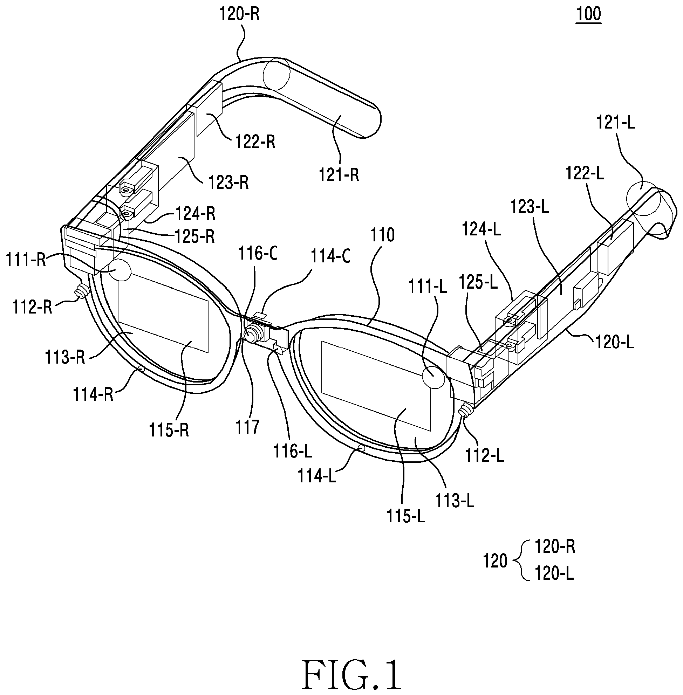

FIG. 1 illustrates an electronic device 100 according to an embodiment of the disclosure.

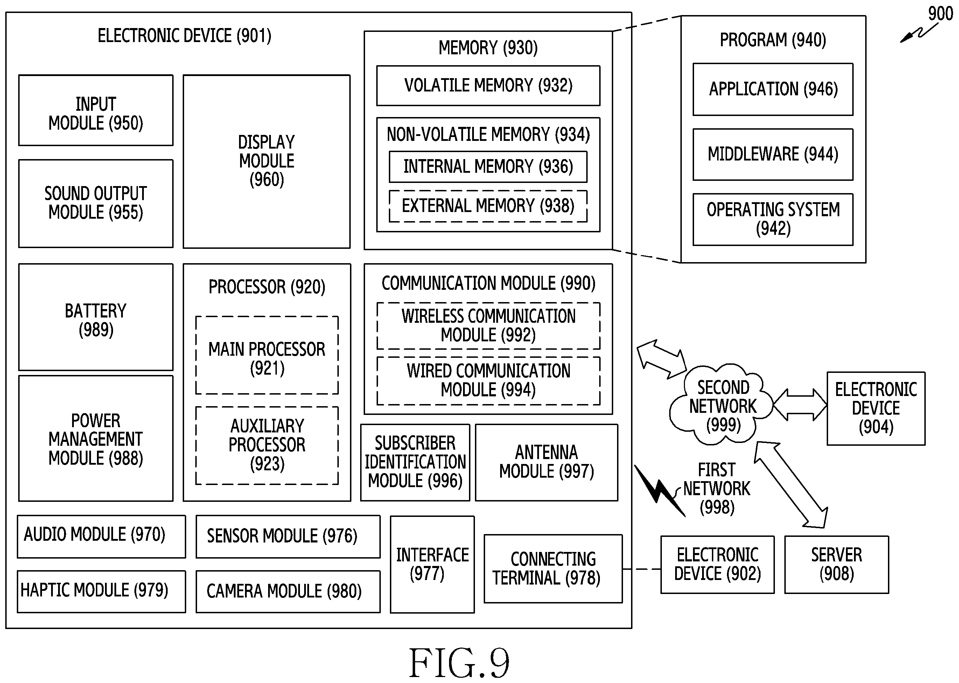

The electronic device 100 of FIG. 1 may include some or all of the components constituting an electronic device 901 of FIG. 9.

In an embodiment, the electronic device 100 includes a frame 110 and a leg member 120. In an example, the leg member 120 may include a first leg member 120-R and a second leg member 120-L.

In an embodiment, the leg member 120 is coupled to at least one side of the frame 110.

In an embodiment, the leg member 120 may be rotatably connected to the frame 110 through hinges 124-L and 124-R, respectively. The first leg member 120-R may be rotatably connected to the frame 110 through the first hinge 124-R, respectively. The second leg member 120-L may be rotatably connected to the frame 110 through the second hinge 124-L, respectively.

In an embodiment, the first leg member 120-R may include the first hinge 124-R, a first printed circuit board (PCB) 123-R, a first speaker 122-R, and/or a first battery 121-R.

In an embodiment, the second leg member 120-L may include the second hinge 124-L, a second printed circuit board (PCB) 123-L, and a second speaker 122-L, and/or a second battery 121-L.

In an embodiment, the frame 110 may include a first optical member 111-R, a first camera 112-R, a first display 115-R, a first microphone 114-R, and a first light output module 125-R, a first optical module 116-R, a third optical module 117, a second optical member 111-L, a second camera 112-L, a second display 115-L, a second microphone 114-L, a third microphone 114-C (center), a second light output module 125-L, and a second optical module 116-L.

In an embodiment, the electronic device 100 may output an image signal by the light output module 125 through the first display 115-R and the second display 115-L.

In an embodiment, "R" and "L" positioned at the end of reference numerals in FIG. 1 may mean constructions positioned on the right and left when the electronic device 100 is worn.

In an embodiment, the construction positioned on the right when the electronic device 100 is worn may be driven by power output from the first battery 121-R. The construction positioned on the left when the electronic device 100 is worn may be driven by power output from the second battery 121-L. In another example, the electronic device 100 may include only any one of the first battery 121-R and the second battery 121-L.

Referring to FIG. 1, the constructions (e.g., the first printed circuit board 123-R, the second printed circuit board 123-L, the first speaker 122-R, the second speaker 122-L, the first battery 121-R, and the second battery 121-L) positioned in the first leg part 120-R and/or the second leg part 120-L are shown to be exposed to the outside, but this is only for convenience of description, and the constructions may not be exposed to the outside because they are positioned inside the first leg part 120-R and/or the second leg part 120-L.

In an embodiment, the first light output module 125-R and the second light output module 125-L may be referred to as the light output module 125. The first printed circuit board 123-R and the second printed circuit board 123-L may be referred to as a printed circuit board 123. The first speaker 122-R and the second speaker 122-L may be referred to as a speaker 122. The first optical member 111-R and the second optical member 111-L may be referred to as an optical member 111. The first display 115-R and the second display 115-L may be referred to as a display 115. The first camera 112-R and the second camera 112-L may be referred to as a camera 112. The first optical module 116-R and the second optical module 116-L may be referred to as an optical module 116. The first optical module 116-R and the second optical module 116-L may be referred to as an optical module (or camera) 116 for eye tracking (ET). The third optical module 117 may be referred to as a photographing camera 117.

In an embodiment, the first camera 112-R and the second camera 112-L may recognize a movement of the user's body (e.g., head or hands) and a space according to 3 degrees of freedom (3DoF) or 6 degrees of freedom (6DoF). The first camera 112-R and the second camera 112-L may include a global shutter camera. The first camera 112-R and the second camera 112-L may perform spatial recognition for 6DoF and simultaneous localization and mapping (SLAM) functions for depth imaging.

In an embodiment, the first optical module 116-R and the second optical module 116-L may detect and track the user's pupil. In the electronic device 100, the center of a virtual image projected on the first display 115-R and the second display 115-L may be located according to a pupil movement of a user wearing the electronic device 100 tracked through the first optical module 116-R and the second optical module 116-L.

In an embodiment, the third camera 117 may include a high resolution (HR) or photo video (PV) camera. In an example, the third camera 117 may perform an auto focus (AF) function and an optical image stabilizer (OIS) function. In an example, the third camera 117 may include a global shutter camera, a color camera, and/or a rolling shutter camera.

In an embodiment, the display member 113 may include the optical member 111 and the display 115.

In an embodiment, the electronic device 100 may be a wearable electronic device. For example, the electronic device 100 may be a wearable electronic device of a glasses form (e.g., augmented reality (AR) glasses, smart glasses, or head mounted device). However, this is only exemplary, and the disclosure is not limited thereto.

In an embodiment, the first display member 113-R may be disposed to face the user's left eye, and the second display member 113-L may be disposed to face the user's right eye.

In an embodiment, the electronic device 100 may acquire an image of the real world through the camera 116, and receive an augmented reality (AR) object related to a location of the acquired image or an object (e.g., a thing or a building) included in the acquired image from another electronic device (e.g., a smart phone, a computer, a tablet personal computer (PC), or a server) and provide to a user through the light output module 125, the optical member 111, and the display 115.

In an embodiment, the camera 112 and the optical module 116 may be used to recognize a current scene or environment which is viewed through the display member 113 of the electronic device 100.

In an embodiment, the electronic device 100 may receive an audio signal through the microphones 114-R, 114-L, and 114-C, and may output an audio signal through the speaker 122.

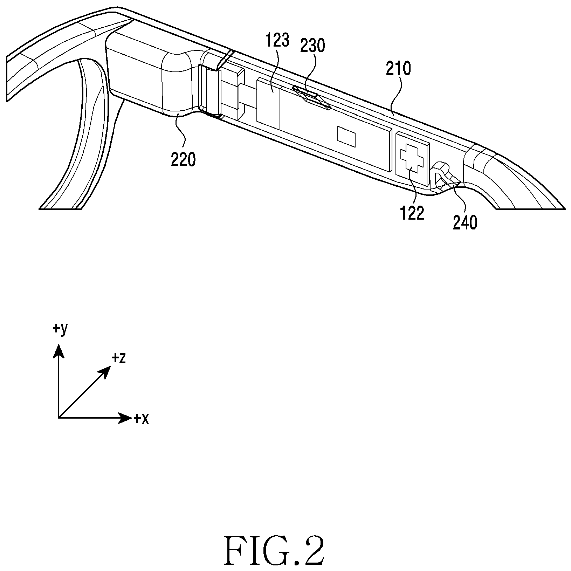

FIG. 2 illustrates one region of the leg member 120 of the electronic device 100 according to an embodiment of the disclosure.

In an embodiment, the leg member 120 may be used as a term referring to the first leg member 120-R or the second leg member 120-L of FIG. 1. Accordingly, the technical features of the leg member 120 to be described later may be applied to the first leg member 120-R and/or the second leg member 120-L.

In an embodiment, the leg member 120 may include a first structure 210 and a second structure 220. The first structure 210 and the second structure 220 may be a cover (or housing) of the leg member 120.

In an embodiment, when the leg member 120 of the electronic device 100 is mounted on the user's body, the first structure 210 may be disposed in a first direction (e.g., a +z direction of FIG. 2) corresponding to an outward direction. When the leg member 120 of the electronic device 100 is mounted on the user's body, the second structure 220 may be disposed in a second direction (e.g., a -z direction of FIG. 2) corresponding to an inward direction adjacent to the user's body.

In an embodiment, the first structure 210 and the second structure 220 may be coupled to each other. Referring to FIG. 2, the first structure 210 and the second structure 220 are illustrated as separable separate structures, but are not limited thereto. For example, the first structure 210 and the second structure 220 may be integrally formed. For another example, the first structure 210 and the second structure 220 may be a structure in which the leg member 120 is divided into a shape different from that shown in FIG. 2 and coupled.

In an embodiment, various electronic components (e.g., the speaker 122, the printed circuit board 123 and/or the light output module 125) may be disposed in a space formed between the first structure 210 and the second structure 220 by the coupling of the first structure 210 and the second structure 220.

Referring to FIG. 2, the speaker 122 and the printed circuit board 123 may be disposed in the space formed between the first structure 210 and the second structure 220. Referring to FIG. 2, the speaker 122 and the printed circuit board 123 disposed in the space formed between the first structure 210 and the second structure 220 are shown to be visible, but this is for convenience of description, and the second structure 220 may be formed of an opaque material.

In an embodiment, the second structure 220 may include a ventilation hole 230 communicating with an internal space and external space formed by the coupling of the first structure 210 and the second structure 220. A heat provided from various electronic components disposed between the first structure 210 and the second structure 220 may be emitted through the ventilation hole 230 disposed in the second structure 220. Referring to FIG. 2, the ventilation hole 230 is disposed at an upper side of the second structure 220 (e.g., a +y direction of FIG. 2), but is not limited thereto. For example, the ventilation hole 230 may be disposed on a side surface of the second structure 220 (e.g., the second direction (e.g., the -z direction of FIG. 2)).

In an embodiment, the second structure 220 may include a sound radiation hole 240. The sound radiation hole 240 may be disposed in a region adjacent to a space in which the speaker 122 is disposed. A sound output from a front surface of the speaker 122 (e.g., the +z direction of FIG. 2) may be output to the outside through the sound radiation hole 240.

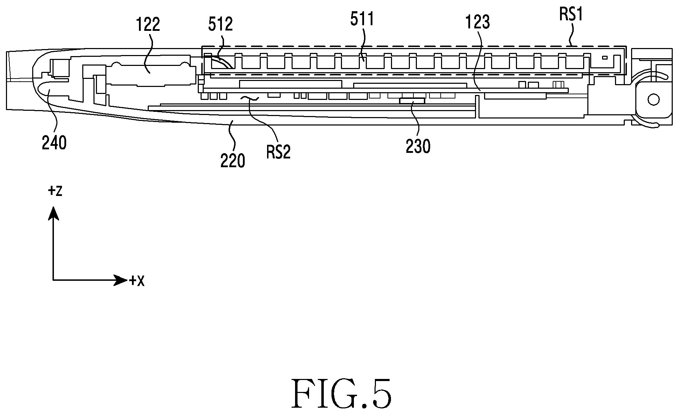

In an embodiment, when the leg member 120 of the electronic device 100 is mounted on the user's body, a resonance space (e.g., a resonance space (RS2) of FIG. 5) connected to a rear surface (e.g., the -z direction of FIG. 2) of the speaker 122 and including a space in which the printed circuit board 123 is disposed may be formed in the second direction (e.g., the -z direction of FIG. 2) corresponding to the inward direction adjacent to the user's body. In this regard, a description will be made in detail with reference to FIG. 5.

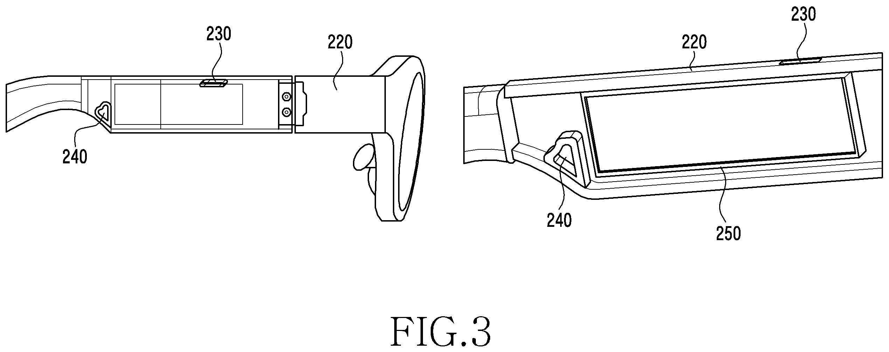

FIG. 3 illustrates a structure forming the leg member 120 of the electronic device 100 according to an embodiment of the disclosure.

Referring to FIG. 3, the second structure 220 may include the ventilation hole 230, the sound radiation hole 240, and a rib 250.

Referring to FIG. 3, the ventilation hole 230, the sound radiation hole 240 and the rib 250 are illustrated as being disposed in the second structure 220, but the ventilation hole 230, the sound radiation hole 240 and the rib 250 may be disposed in the first structure 210 and/or the second structure 220.

In an embodiment, the second structure 220 may include the rib 250 for mounting a printed circuit board (e.g., the printed circuit board 123 of FIG. 2) and a speaker (e.g., the speaker 122 of FIG. 2). The rib 250 may correspond to a protrusion which is formed to form an internal space of the leg member 120 by coupling the first structure 210 and the second structure 220. Referring to FIG. 3, the rib 250 is illustrated as a protrusion having an entire rectangular shape, but is not limited thereto. For example, the rib 250 may include a protrusion having various shapes. For another example, the rib 250 may be replaced with a recess for accommodating a component mounted in the internal space of the leg member 120.

In an embodiment, the rib 250 of the second structure 220 may be formed in the second direction (e.g., the -z direction of FIG. 3) corresponding to the inward direction in which the user's body is positioned when a user wears the electronic device 100 by means of the leg member 120.

In an embodiment, the second structure 220 may include the sound radiation hole 240. In an example, a sound provided from the speaker 122 may be radiated to the outside through the sound radiation hole 240. Referring to FIG. 3, the sound radiation hole 240 may be disposed at a lower left side of the second structure 220. A speaker (e.g., the speaker 122 of FIG. 2) may be disposed in a region adjacent to the sound radiation hole 240.

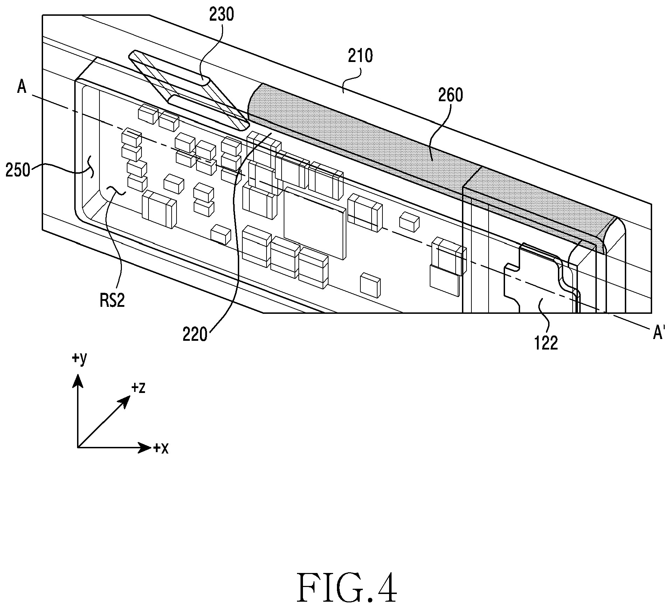

FIG. 4 illustrates one region of the leg member 120 of the electronic device 100 according to an embodiment of the disclosure.

In an embodiment, the printed circuit board 123 and the speaker 122 may be disposed in an internal space formed through the first structure 210 and the second structure 220 of the leg member 120.

In an embodiment, an antenna module (e.g., an antenna module 997 of FIG. 9), a memory (e.g., a memory 930 of FIG. 9), a processor (e.g., a processor 920 of FIG. 9) and/or a power management module (e.g., a power management module 988 of FIG. 9) may be disposed in the other surface of the printed circuit board 123 facing a first direction (e.g., a +z direction of FIG. 4) and/or one surface of the printed circuit board 123 facing a second direction (e.g., a -z direction of FIG. 4). However, the components disposed on the printed circuit board 123 are not limited thereto.

In an embodiment, a waterproof member (not shown) may be disposed in a region surrounding the inside of the ventilation hole 230 in order to prevent moisture from being introduced into the ventilation hole 230. In an example, the waterproof member may include at least one of a waterproof tape, a waterproof membrane, or a waterproof member (e.g., porous material, Gore-Tex).

In an embodiment, the printed circuit board 123 and the speaker 122 may be accommodated by the rib 250 formed in the second structure 220. The internal space formed by the coupling of the first structure 210 and the second structure 220 may be connected to the rear surface (e.g., the -z direction of FIG. 4) of the speaker 122, and may include a resonance space (e.g., a resonance space (RS2) of FIG. 5) including a region in which the printed circuit board 123 is disposed. Accordingly, a sound output from the speaker 122 may be expanded through the resonance space connected to the rear surface of the speaker 122.

In an embodiment, the ventilation hole 230 may be disposed in at least one region of the rib 250 disposed in the second structure 220, to be connected to the resonance space (RS2) included in the internal space formed by the coupling of the first structure 210 and the second structure 220.

In an embodiment, a sealing member 260 may be disposed in a region in which the rib 250 and the speaker 122 contact with each other and in a region in which the rib 250 and the printed circuit board 123 contact with each other. The sealing member 260 may be disposed in the region where the rib 250 and the speaker 122 contact with each other and the region where the rib 250 and the printed circuit board 123 contact with each other, thereby preventing a sound leakage from the rear surface of the speaker 122 and ensuring the performance of a back volume output to the rear surface of the speaker 122 through the resonance space (RS2).

In an embodiment, the sealing member 260 may include Poron. However, the disclosure is not limited thereto. For example, the sealing member 260 may include at least one of a sponge, a tape, a rubber, a silicone rubber, and urethane.

In an embodiment, the sealing member 260 may be formed in a closed curve that is formed along a circumference of the rib 250 for accommodating the speaker 122 and the printed circuit board 123.

FIG. 5 is a cross-sectional view taken along line A-A' of the leg member 120 of FIG. 4 according to an embodiment of the disclosure.

Referring to FIG. 5, the internal space formed by the coupling of the first structure 210 and the second structure 220 may include a radiating space (RS1) and a resonance space (RS2).

Referring to FIG. 5, the speaker 122 may include a front surface and a rear surface. In an example, the front surface (e.g., a +z direction of FIG. 5) of the speaker 122 may be one surface through which a sound output from the speaker 122 is directly radiated and connected to the sound radiation hole 240. The rear surface (e.g., a -z direction of FIG. 5) of the speaker 122 may be one surface facing the front surface of the speaker 122. The speaker 122 may be disposed in a seating region of the speaker 122 wherein the front surface of the speaker 122 faces the rear surface of the speaker 122. The front surface of the speaker 122 may be connected to the sound radiation hole 240 and output a sound in a first direction (e.g., the +z direction of FIG. 5). The rear surface of the speaker 122 may be connected to the resonance space (RS2) for providing a resonance with respect to a sound radiated in a second direction (the -z direction of FIG. 5).

In an embodiment, the front surface of the speaker 122 may be connected to a space connected to the sound radiation hole 240 distinguished from the radiating space (RS1).

In an embodiment, the rear surface of the speaker 122 may be connected to the resonance space (RS2) including a region in which the printed circuit board 123 is disposed.

In an embodiment, the printed circuit board 123 may include one surface facing the second direction and the other surface facing the first direction. In an embodiment, a first electronic component (not shown) may be disposed on the other surface of the printed circuit board 123. A second electronic component (not shown) may be disposed on one surface of the printed circuit board 123.

In an embodiment, the other surface of the printed circuit board 123 may be connected to the radiating space (RS1). In an example, the radiating space (RS1) may include a heat radiating member (e.g., a first heat radiating member 511 and/or a second heat radiating member 512). In an example, the second heat radiating member 512 may be disposed at a position where the printed circuit board 123 is adjacent. The first heat radiating member 511 may be disposed in a first direction of the second heat radiating member 512. The first heat radiating member 511 and the second heat radiating member 512 may include a radiating plate, a heat pipe, a thermal interface material (TIM), or a graphite sheet.

In an embodiment, a heat emitted from the first electronic component disposed on the other surface of the printed circuit board 123 may be emitted (or diffused) to the outside through the heat radiating member (e.g., the first heat radiating member 511 and/or the second heat radiating member 512).

In an embodiment, a heat provided by the printed circuit board 123 may be more effectively radiated through the radiating space (RS1) connected to the other surface of the printed circuit board 123 than the resonance space (RS2) connected to the one surface of the printed circuit board 123. Accordingly, the first electronic component having higher power consumption than the second electronic component disposed on the one surface of the printed circuit board 123 may be disposed on the other surface of the printed circuit board 123.

In an embodiment, the resonance space (RS2) may be connected to the rear surface of the speaker 122 and be connected to at least one ventilation hole 230 formed in at least one region of the rib 250.

In an embodiment, when the speaker 122 provides a sound of a full frequency band, a hole of a predetermined size or more is essential for sound radiation. Accordingly, the speaker 122 may radiate a sound to the outside through the sound radiation hole 240 connected to the front surface of the speaker 122 and the ventilation hole 230 connected to the rear surface of the speaker 122. The ventilation hole 230 may function as a damping hole for the speaker 122.

In an embodiment, a heat provided from the second electronic component (not shown) disposed on the one surface (e.g., the -z direction of FIG. 5) of the printed circuit board 123 may be diffused into the resonance space (RS2) and be diffused to the outside through the ventilation hole 230 connected to the resonance space (RS2). The ventilation hole 230 may function as an air vent hole wherein a heat provided by the printed circuit board 123 may be discharged.

In an embodiment, a heat radiating member (not shown) may be disposed in a region adjacent to the resonance space (RS2). For example, a graphite sheet may be attached as the heat radiating member to at least one region adjacent to the one surface of the printed circuit board 123 in the rib 250 of the second structure 220.

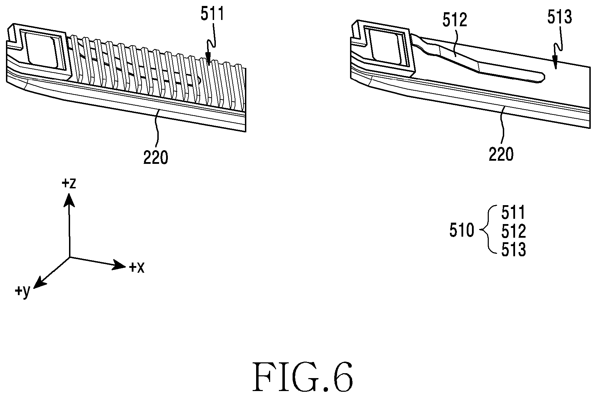

FIG. 6 illustrates a heat radiating member 510 included in the leg member 120 of the electronic device 100 according to an embodiment of the disclosure.

In an embodiment, the heat radiating member 510 disposed in the radiating space (RS1) of FIG. 5 may include a first heat radiating member 511, a second heat radiating member 512, and a third heat radiating member 513.

In an embodiment, the heat radiating member 510 may be disposed in the radiating space (RS1) connected to the other surface of the printed circuit board 123.

In an embodiment, in the heat radiating member 510, the third heat radiating member 513, the second heat radiating member 512, and the first heat radiating member 511 may be sequentially disposed in a first direction (e.g., a +z direction of FIG. 6). In an example, the first heat radiating member 511 may include a radiating plate. The first heat radiating member 511 may include an aluminum material. The first heat radiating member 511 may have a plurality of protrusions protruded in the first direction. The plurality of protrusions of the first heat radiating member 511 may guide a heat radiating direction. The second heat radiating member 512 may include a heat pipe. The third heat radiating member 513 may include a graphite sheet.

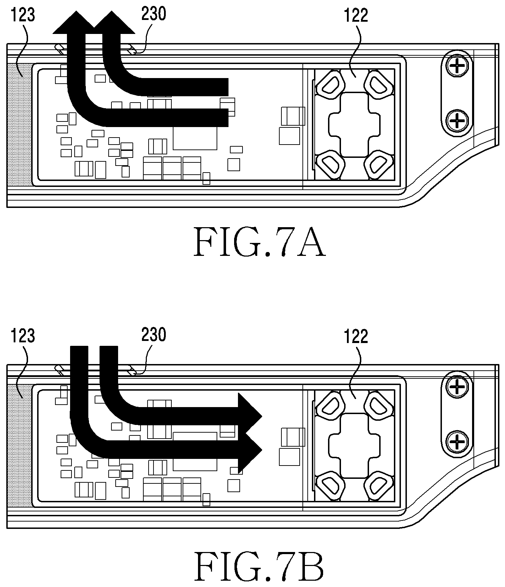

FIGS. 7A and 7B illustrates a heat radiating path dependent on the provision of a sound pressure of the speaker 122 included in the leg member 120 of the electronic device 101 according to various embodiments of the disclosure.

FIG. 7A shows that air is discharged from the resonance space (RS2) through the ventilation hole 230. When the resonance space (RS2) corresponds to a positive sound pressure according to a sound provided by the speaker 122 and thus a pressure of the resonance space (RS2) is higher than that of an external space connected to the ventilation hole 230, air within the resonance space (RS2) may be emitted to the outside

FIG. 7B illustrates that air is introduced into the resonance space (RS2) through the ventilation hole 230. When the resonance space (RS2) corresponds to a negative sound pressure according to a sound provided by the speaker 122 and thus the pressure of the resonance space (RS2) is lower than that of the external space connected to the ventilation hole 230, air may be introduced into the resonance space (RS2).

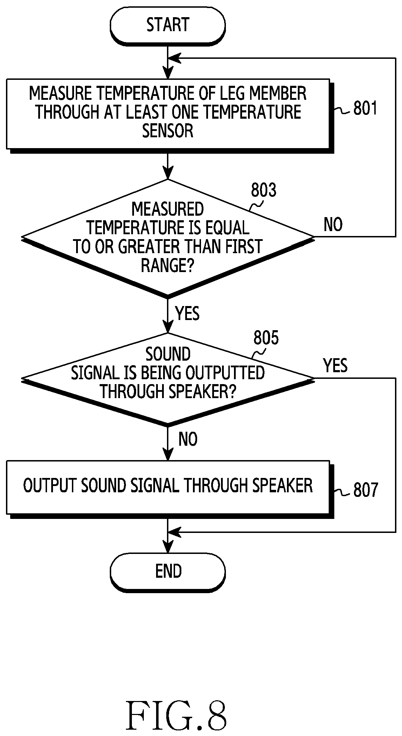

FIG. 8 is a flowchart for controlling a speaker according to a temperature of an electronic device according to an embodiment of the disclosure.

In operation 801, the electronic device 100 (e.g., a processor 920 of FIG. 9) of an embodiment may measure a temperature of the leg member 120 through at least one temperature sensor.

In an embodiment, the leg member 120 may include at least one temperature sensor. In an example, the at least one temperature sensor may be disposed in a position adjacent to the printed circuit board 123 and/or the speaker 122 included in the leg member 120. The electronic device 100 may sense a temperature of the leg member 120, through the at least one temperature sensor disposed in the position adjacent to the printed circuit board 123 and/or the speaker 122. In an example, the electronic device 100 may measure a temperature of a module disposed on the printed circuit board 123 and/or a temperature of an amplifier included in the speaker 122, through the at least one temperature sensor.

In operation 803, the electronic device 100 (e.g., the processor 920 of FIG. 9) of an embodiment may determine whether the temperature measured by the at least one temperature sensor is equal to or greater than a first temperature range.

In an embodiment, when the temperature measured by the at least one temperature sensor is equal to or greater than a first temperature (e.g., about 40°C), the electronic device 100 may control the speaker 122 in order to radiate a heat provided by various electronic components (e.g., the speaker 122 and/or the printed circuit board 123 of FIG. 1) disposed in the leg member 120.

When the temperature measured by the at least one temperature sensor is equal to or greater than the first temperature range in operation 803, the electronic device 100 (e.g., the processor 920 of FIG. 9) of an embodiment may, in operation 805, determine whether a sound signal is being output through the speaker 122.

In an embodiment, when a sound signal is being output through the speaker 122 in the electronic device 100, a sound pressure by a sound is formed in the resonance space (RS2) connected to the rear surface of the speaker 122 and thus, air within the resonance space (RS2) may be circulated through the ventilation hole 230.

In an embodiment, when the sound signal is not being output through the speaker 122, the electronic device 100 may control the speaker 122 to output the sound signal . The sound signal output through the speaker 122 through the control of the electronic device 100 may include an inaudible frequency signal (e.g., a frequency of about 20 Hz or less).

FIG. 9 is a block diagram illustrating an electronic device 901 in a network environment 900 according to an embodiment of the disclosure.

Referring to FIG. 9, the electronic device 901 in the network environment 900 may communicate with an electronic device 902 via a first network 998 (e.g., a short-range wireless communication network), or at least one of an electronic device 904 or a server 908 via a second network 999 (e.g., a long-range wireless communication network). According to an embodiment, the electronic device 901 may communicate with the electronic device 904 via the server 908. According to an embodiment, the electronic device 901 may include a processor 920, memory 930, an input module 950, a sound output module 955, a display module 960, an audio module 970, a sensor module 976, an interface 977, a connecting terminal 978, a haptic module 979, a camera module 980, a power management module 988, a battery 989, a communication module 990, a subscriber identification module (SIM) 996, or an antenna module 997. In some embodiments, at least one of the components (e.g., the 99connecting terminal 978) may be omitted from the electronic device 901, or one or more other components may be added in the electronic device 901. In some embodiments, some of the components (e.g., the sensor module 976, the camera module 980, or the antenna module 997) may be implemented as a single component (e.g., the display module 960).

The processor 920 may execute, for example, software (e.g., a program 940) to control at least one other component (e.g., a hardware or software component) of the electronic device 901 coupled with the processor 920, and may perform various data processing or computation. According to one embodiment, as at least part of the data processing or computation, the processor 920 may store a command or data received from another component (e.g., the sensor module 976 or the communication module 990) in volatile memory 932, process the command or the data stored in the volatile memory 932, and store resulting data in non-volatile memory 934. According to an embodiment, the processor 920 may include a main processor 921 (e.g., a central processing unit (CPU) or an application processor (AP)), or an auxiliary processor 923 (e.g., a graphics processing unit (GPU), a neural processing unit (NPU), an image signal processor (ISP), a sensor hub processor, or a communication processor (CP)) that is operable independently from, or in conjunction with, the main processor 921. For example, when the electronic device 901 includes the main processor 921 and the auxiliary processor 923, the auxiliary processor 923 may be adapted to consume less power than the main processor 921, or to be specific to a specified function. The auxiliary processor 923 may be implemented as separate from, or as part of the main processor 921.

The auxiliary processor 923 may control at least some of functions or states related to at least one component (e.g., the display module 960, the sensor module 976, or the communication module 990) among the components of the electronic device 901, instead of the main processor 921 while the main processor 921 is in an inactive (e.g., sleep) state, or together with the main processor 921 while the main processor 921 is in an active state (e.g., executing an application). According to an embodiment, the auxiliary processor 923 (e.g., an image signal processor or a communication processor) may be implemented as part of another component (e.g., the camera module 980 or the communication module 990) functionally related to the auxiliary processor 923. According to an embodiment, the auxiliary processor 923 (e.g., the neural processing unit) may include a hardware structure specified for artificial intelligence model processing. An artificial intelligence model may be generated by machine learning. Such learning may be performed, e.g., by the electronic device 901 where the artificial intelligence is performed or via a separate server (e.g., the server 908). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 930 may store various data used by at least one component (e.g., the processor 920 or the sensor module 976) of the electronic device 901. The various data may include, for example, software (e.g., the program 940) and input data or output data for a command related thereto. The memory 930 may include the volatile memory 932 or the non-volatile memory 934.

The program 940 may be stored in the memory 930 as software, and may include, for example, an operating system (OS) 942, middleware 944, or an application 946.

The input module 950 may receive a command or data to be used by another component (e.g., the processor 920) of the electronic device 901, from the outside (e.g., a user) of the electronic device 901. The input module 950 may include, for example, a microphone, a mouse, a keyboard, a key (e.g., a button), or a digital pen (e.g., a stylus pen).

The sound output module 955 may output sound signals to the outside of the electronic device 901. The sound output module 955 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 960 may visually provide information to the outside (e.g., a user) of the electronic device 901. The display module 960 may include, for example, a display, a hologram device, or a projector and control circuitry to control a corresponding one of the display, hologram device, and projector. According to an embodiment, the display module 960 may include a touch sensor adapted to detect a touch, or a pressure sensor adapted to measure the intensity of force incurred by the touch.

The audio module 970 may convert a sound into an electrical signal and vice versa. According to an embodiment, the audio module 970 may obtain the sound via the input module 950, or output the sound via the sound output module 955 or a headphone of an external electronic device (e.g., an electronic device 902) directly (e.g., wiredly) or wirelessly coupled with the electronic device 901.

The sensor module 976 may detect an operational state (e.g., power or temperature) of the electronic device 901 or an environmental state (e.g., a state of a user) external to the electronic device 901, and then generate an electrical signal or data value corresponding to the detected state. According to an embodiment, the sensor module 976 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 977 may support one or more specified protocols to be used for the electronic device 901 to be coupled with the external electronic device (e.g., the electronic device 902) directly (e.g., wiredly) or wirelessly. According to an embodiment, the interface 977 may include, for example, a high definition multimedia interface (HDMI), a universal serial bus (USB) interface, a secure digital (SD) card interface, or an audio interface.

A connecting terminal 978 may include a connector via which the electronic device 901 may be physically connected with the external electronic device (e.g., the electronic device 902). According to an embodiment, the connecting terminal 978 may include, for example, an HDMI connector, a USB connector, an SD card connector, or an audio connector (e.g., a headphone connector).

The haptic module 979 may convert an electrical signal into a mechanical stimulus (e.g., a vibration or a movement) or electrical stimulus which may be recognized by a user via his tactile sensation or kinesthetic sensation. According to an embodiment, the haptic module 979 may include, for example, a motor, a piezoelectric element, or an electric stimulator.

The camera module 980 may capture a still image or moving images. According to an embodiment, the camera module 980 may include one or more lenses, image sensors, image signal processors, or flashes.

The power management module 988 may manage power supplied to the electronic device 901. According to one embodiment, the power management module 988 may be implemented as at least part of, for example, a power management integrated circuit (PMIC).

The battery 989 may supply power to at least one component of the electronic device 901. According to an embodiment, the battery 989 may include, for example, a primary cell which is not rechargeable, a secondary cell which is rechargeable, or a fuel cell.

The communication module 990 may support establishing a direct (e.g., wired) communication channel or a wireless communication channel between the electronic device 901 and the external electronic device (e.g., the electronic device 902, the electronic device 904, or the server 908) and performing communication via the established communication channel. The communication module 990 may include one or more communication processors that are operable independently from the processor 920 (e.g., the application processor (AP)) and supports a direct (e.g., wired) communication or a wireless communication. According to an embodiment, the communication module 990 may include a wireless communication module 992 (e.g., a cellular communication module, a short-range wireless communication module, or a global navigation satellite system (GNSS) communication module) or a wired communication module 994 (e.g., a local area network (LAN) communication module or a power line communication (PLC) module). A corresponding one of these communication modules may communicate with the external electronic device via the first network 998 (e.g., a short-range communication network, such as Bluetooth^{™}, Wi-Fi direct, or infrared data association (IrDA)) or the second network 999 (e.g., a long-range communication network, such as a legacy cellular network, a 5th generation (5G) network, a next-generation communication network, the Internet, or a computer network (e.g., LAN or wide area network (WAN))). These various types of communication modules may be implemented as a single component (e.g., a single chip), or may be implemented as multi components (e.g., multi chips) separate from each other. The wireless communication module 992 may identify and authenticate the electronic device 901 in a communication network, such as the first network 998 or the second network 999, using subscriber information (e.g., international mobile subscriber identity (IMSI)) stored in the subscriber identification module 996.

The wireless communication module 992 may support a 5G network, after a 4th generation (4G) network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 992 may support a high-frequency band (e.g., the millimeter wave (mmWave) band) to achieve, e.g., a high data transmission rate. The wireless communication module 992 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 992 may support various requirements specified in the electronic device 901, an external electronic device (e.g., the electronic device 904), or a network system (e.g., the second network 999). According to an embodiment, the wireless communication module 992 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 997 may transmit or receive a signal or power to or from the outside (e.g., the external electronic device) of the electronic device 901. According to an embodiment, the antenna module 997 may include an antenna including a radiating element composed of a conductive material or a conductive pattern formed in or on a substrate (e.g., a printed circuit board (PCB)). According to an embodiment, the antenna module 997 may include a plurality of antennas (e.g., array antennas). In such a case, at least one antenna appropriate for a communication scheme used in the communication network, such as the first network 998 or the second network 999, may be selected, for example, by the communication module 990 (e.g., the wireless communication module 992) from the plurality of antennas. The signal or the power may then be transmitted or received between the communication module 990 and the external electronic device via the selected at least one antenna. According to an embodiment, another component (e.g., a radio frequency integrated circuit (RFIC)) other than the radiating element may be additionally formed as part of the antenna module 997.

According to various embodiments, the antenna module 997 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 901 and the external electronic device 904 via the server 908 coupled with the second network 999. Each of the electronic devices 902 or 904 may be a device of a same type as, or a different type, from the electronic device 901. According to an embodiment, all or some of operations to be executed at the electronic device 901 may be executed at one or more of the external electronic devices 902, 904, or 908. For example, if the electronic device 901 should perform a function or a service automatically, or in response to a request from a user or another device, the electronic device 901, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 901. The electronic device 901 may provide the outcome, with or without further processing of the outcome, as at least part of a reply to the request. To that end, a cloud computing, distributed computing, mobile edge computing (MEC), or client-server computing technology may be used, for example. The electronic device 901 may provide ultra low-latency services using, e.g., distributed computing or mobile edge computing. In another embodiment, the external electronic device 904 may include an internet-of-things (IoT) device. The server 908 may be an intelligent server using machine learning and/or a neural network. According to an embodiment, the external electronic device 904 or the server 908 may be included in the second network 999. The electronic device 901 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively," as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry." A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 940) including one or more instructions that are stored in a storage medium (e.g., internal memory 936 or external memory 938) that is readable by a machine (e.g., the electronic device 901). For example, a processor (e.g., the processor 920) of the machine (e.g., the electronic device 901) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment not covered by the subject matter of the claims, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

An electronic device of various embodiments includes a display member including at least one glass, a frame supporting at least a portion of the display member, and a leg member coupled to at least one side of the frame. The leg member includes a first structure, a second structure possible to be coupled with the first structure, a speaker disposed in a space formed between the first structure and the second structure, a printed circuit board disposed in the space formed between the first structure and the second structure, and a rib included in at least one of the first structure or the second structure and accommodating the printed circuit board. A rear surface of the speaker is disposed to face a resonance space formed between the first structure and the second structure, and the resonance space includes a space in which the printed circuit board is disposed, and may be connected to at least one ventilation hole formed in at least one region of the rib so as to be connected to the outside of the leg member.

One surface of the printed circuit board of an embodiment may be disposed to face the resonance space, and the other surface of the printed circuit board may be disposed to face a radiating space separated from the resonance space.

A first electronic component of an embodiment may be disposed on the other surface of the printed circuit board disposed to be connected to the radiating space, and a second electronic component consuming less power than the first electronic component may be disposed on the one surface of the circuit board disposed to be connected to the resonance space.

At least one of a radiating plate, a heat pipe, a thermal interface material (TIM), and a graphite sheet of an embodiment may be disposed in the radiating space.

The first structure or the second structure of an embodiment may form a space connecting a sound radiation hole, which is formed in at least one of the first structure or second structure, and a front surface of the speaker.

The electronic device of an embodiment may further include a waterproof member for preventing moisture from being introduced into the ventilation hole, in a region surrounding the inside of the ventilation hole.

The waterproof member of an embodiment may include at least one of a waterproof mesh, a waterproof tape, a waterproof membrane, and a Gore-Tex member.

The electronic device of an embodiment may further include a sealing member in at least one region of the rib for accommodating the speaker and the printed circuit board.

The sealing member of an embodiment may include Poron.

The sealing member of an embodiment may be configured in a closed curve shape along a circumference of the rib accommodating the speaker and the printed circuit board.

The at least one ventilation hole of an embodiment may be disposed in at least one region of an upper portion or a lower portion of the rib.

The electronic device of an embodiment may further include at least one temperature sensor disposed in the space formed between the first structure and the second structure, and at least one processor electrically connected to the speaker, the printed circuit board, or the at least one temperature sensor. The at least one processor may measure a temperature of the leg member through the at least one temperature sensor, determine whether the measured temperature is equal to or greater than a first temperature, and when the measured temperature is equal to or greater than the first temperature, determine whether a sound signal is being output through the speaker, and when the sound signal is not being output through the speaker, output the sound signal through the speaker.

When the sound signal is not being output through the speaker, the at least one processor of an embodiment may adjust a volume intensity of the speaker and output an inaudible frequency signal.

The inaudible frequency signal of an embodiment may include a frequency domain of about 20 Hz or less.

The electronic device of an embodiment may further include an amplifier electrically connected to the speaker.

An electronic device includes a display member including at least one glass, a frame supporting at least a portion of the display member, and a leg member coupled to at least one side of the frame. In some embodiments not covered by the subject matter of the claims the leg member may include a housing, a speaker disposed in a space formed inside the housing, a printed circuit board disposed in the space formed inside the housing, and a rib for accommodating the printed circuit board in at least one region of the housing. A rear surface of the speaker may be disposed to face a resonance space formed inside the housing, and the resonance space may include a space in which the printed circuit board is disposed, and may be connected to at least one ventilation hole formed in at least one region of the rib so as to be connected to the outside of the leg member.

The housing of an embodiment not covered by the subject-matter of the claims may have a sound radiation hole formed in at least one region of the housing, and a space connected to the front surface of the speaker.

The electronic device of an embodiment may further include a waterproof member in a region surrounding the inside of the at least one ventilation hole.

The electronic device of an embodiment not covered by the subject-matter of the claims may further include at least one temperature sensor disposed in a space formed inside the housing, and at least one processor electrically connected to the speaker, the printed circuit board, or the at least one temperature sensor. The at least one processor may measure a temperature of the leg member through the at least one temperature sensor, determine whether the measured temperature is equal to or greater than a first temperature, and when the measured temperature is equal to or greater than the first temperature, determine whether a sound signal is being output through the speaker, and when the sound signal is not being output through the speaker, output the sound signal through the speaker.

When the sound signal is not being output through the speaker, the at least one processor of an embodiment may adjust a volume intensity of the speaker and output an inaudible frequency signal.

## Claims

1. An electronic device (100) comprising:
a display member (115) comprising at least one glass (113);
a frame (110) supporting at least a portion of the display member; and
a leg member (120) coupled to at least one side of the frame,
wherein the leg member comprises:
a first structure (210),
a second structure (220) coupled with the first structure,
a speaker (122) disposed in a space formed between the first structure and the second structure,
a printed circuit board (123) disposed in the space formed between the first structure and the second structure, and
a rib (250) comprised in at least one of the first structure or the second structure and accommodating the printed circuit board,
wherein a rear surface of the speaker is disposed to face a resonance space (RS2) formed between the first structure and the second structure, **characterized in that**
the resonance space comprises a space in which the printed circuit board is disposed, and is connected to at least one ventilation hole (230) formed in at least one region of the rib, the at least one ventilation hole connecting the resonance space to an outside of the leg member.

2. The electronic device of claim 1,
wherein one surface of the printed circuit board is disposed to face the resonance space, and
wherein another surface of the printed circuit board is disposed to face a radiating space (RS1) separated from the resonance space.

3. The electronic device of claim 2,
wherein a first electronic component is disposed on the other surface of the printed circuit board to be connected to the radiating space, and
wherein a second electronic component consuming less power than the first electronic component consumes is disposed on the one surface of the circuit board and connected to the resonance space.

4. The electronic device of claim 2, wherein at least one of a radiating plate, a heat pipe, a thermal interface material (TIM), or a graphite sheet is disposed in the radiating space.

5. The electronic device of claim 1, wherein the first structure or the second structure forms a space connecting a sound radiation hole, which is formed in at least one of the first structure or second structure, to a front surface of the speaker.

6. The electronic device of claim 1, further comprising a waterproof member configured to prevent moisture from being introduced into the ventilation hole, in a region surrounding an inside of the ventilation hole.

7. The electronic device of claim 1, further comprising a sealing member in at least one region of the rib, the sealing member being configured to accommodate the speaker and the printed circuit board.

8. The electronic device of claim 7, wherein the sealing member (260) is further configured in a closed curve shape along a circumference of the rib accommodating the speaker and the printed circuit board.

9. The electronic device of claim 1, wherein the at least one ventilation hole is disposed in at least one region of an upper portion or a lower portion of the rib.

10. The electronic device of claim 1, further comprising:
at least one temperature sensor disposed in the space formed between the first structure and the second structure; and
at least one processor (920) electrically connected to the speaker, the printed circuit board, and the at least one temperature sensor,
wherein the at least one processor is configured to:
measure a temperature of the leg member through the at least one temperature sensor,
determine whether the measured temperature is equal to or greater than a first temperature,
when the measured temperature is equal to or greater than the first temperature, determine whether a sound signal is being output through the speaker, and
when the sound signal is not being output through the speaker, output the sound signal through the speaker.

11. The electronic device of claim 10, wherein, when the sound signal is not being output through the speaker, the at least one processor is further configured to adjust a volume intensity of the speaker and output an inaudible frequency signal.

12. The electronic device of claim 11, wherein the inaudible frequency signal comprises a frequency domain of about 20 Hz or less.

13. The electronic device of claim 10, further comprising an amplifier electrically connected to the speaker.

14. The electronic device of claim 10, further comprising a heat radiating member (511, 512) disposed in a radiating space.

15. The electronic device of claim 14, wherein the heat radiating member comprises at least one of a first heat radiating member (511) having a plurality of protrusions, a second heat radiating member (512) comprising a heat pipe, or a third heat radiating member comprising a graphite sheet.

## Patentansprüche

1. Elektronische Vorrichtung (100), die Folgendes umfasst:
ein Display-Element (115), das mindestens ein Glas (113) umfasst;
einen Rahmen (110), der mindestens einen Teil des Display-Elements trägt; und
ein Beinelement (120), das mit mindestens einer Seite des Rahmens gekoppelt ist,
wobei das Beinelement Folgendes umfasst:
eine erste Struktur (210),
eine zweite Struktur (220), die mit der ersten Struktur gekoppelt ist,
einen Lautsprecher (122), der in einem Raum angeordnet ist, der zwischen der ersten Struktur und der zweiten Struktur gebildet ist,
eine Leiterplatte (123), die in dem Raum angeordnet ist, der zwischen der ersten Struktur und der zweiten Struktur gebildet ist, und
eine Rippe (250), die in der ersten Struktur und/oder der zweiten Struktur enthalten ist und die Leiterplatte aufnimmt,
wobei eine Rückfläche des Lautsprechers so angeordnet ist, dass sie einem Resonanzraum (RS2) zugewandt ist, der zwischen der ersten Struktur und der zweiten Struktur gebildet ist, **dadurch gekennzeichnet, dass**
der Resonanzraum einen Raum umfasst, in dem die Leiterplatte angeordnet ist, und mit mindestens einem Belüftungsloch (230) verbunden ist, das in mindestens einem Bereich der Rippe gebildet ist, wobei das mindestens eine Belüftungsloch den Resonanzraum mit einer Außenseite des Beinelements verbindet.

2. Elektronische Vorrichtung nach Anspruch 1,
wobei eine Oberfläche der Leiterplatte so angeordnet ist, dass sie dem Resonanzraum zugewandt ist, und
wobei eine andere Oberfläche der Leiterplatte so angeordnet ist, dass sie einem Strahlungsraum (RS1) zugewandt ist, der von dem Resonanzraum getrennt ist.

3. Elektronische Vorrichtung nach Anspruch 2,
wobei eine erste elektronische Komponente auf der anderen Oberfläche der Leiterplatte angeordnet ist, um mit dem Strahlungsraum verbunden zu werden, und
wobei eine zweite elektronische Komponente, die weniger Strom als die erste elektronische Komponente verbraucht, auf der einen Oberfläche der Leiterplatte angeordnet und mit dem Resonanzraum verbunden ist.

4. Elektronische Vorrichtung nach Anspruch 2, wobei eine Strahlungsplatte, ein Wärmerohr, ein thermisches Schnittstellenmaterial (TIM) und/oder eine Graphitschicht in dem Strahlungsraum angeordnet sind.

5. Elektronische Vorrichtung nach Anspruch 1, wobei die erste Struktur oder die zweite Struktur einen Raum bildet, der ein Schallabstrahlungsloch, das in der ersten Struktur und/oder der zweiten Struktur gebildet ist, mit einer Vorderseite des Lautsprechers verbindet.

6. Elektronische Vorrichtung nach Anspruch 1, die ferner ein wasserdichtes Element umfasst, das so konfiguriert ist, dass es das Eindringen von Feuchtigkeit in das Belüftungsloch in einem Bereich verhindert, der eine Innenseite des Belüftungslochs umgibt.

7. Elektronische Vorrichtung nach Anspruch 1, die ferner ein Dichtungselement in mindestens einem Bereich der Rippe umfasst, wobei das Dichtelement so konfiguriert ist, dass es den Lautsprecher und die Leiterplatte aufnimmt.

8. Elektronische Vorrichtung nach Anspruch 7, wobei das Dichtungselement (260) ferner in einer geschlossenen Kurvenform entlang eines Umfangs der Rippe konfiguriert ist, die den Lautsprecher und die Leiterplatte aufnimmt.

9. Elektronische Vorrichtung nach Anspruch 1, wobei das mindestens eine Belüftungsloch in mindestens einem Bereich eines oberen Abschnitts oder eines unteren Abschnitts der Rippe angeordnet ist.

10. Elektronische Vorrichtung nach Anspruch 1, die ferner Folgendes umfasst:
mindestens einen Temperatursensor, der in dem zwischen der ersten Struktur und der zweiten Struktur gebildeten Raum angeordnet ist; und
mindestens einen Prozessor (920), der mit dem Lautsprecher, der Leiterplatte und dem mindestens einen Temperatursensor elektrisch verbunden ist,
wobei der mindestens eine Prozessor zu Folgendem konfiguriert ist:
Messen einer Temperatur des Beinelements durch den mindestens einen Temperatursensor,
Bestimmen, ob die gemessene Temperatur gleich oder größer als eine erste Temperatur ist,
wenn die gemessene Temperatur gleich oder größer als die erste Temperatur ist, Bestimmen, ob ein Tonsignal über den Lautsprecher ausgegeben wird, und
wenn das Tonsignal nicht über den Lautsprecher ausgegeben wird, Ausgeben des Tonsignals über den Lautsprecher.

11. Elektronische Vorrichtung nach Anspruch 10, wobei der mindestens eine Prozessor ferner so konfiguriert ist, dass er eine Lautstärkeintensität des Lautsprechers anpasst und ein unhörbares Frequenzsignal ausgibt, wenn das Tonsignal nicht über den Lautsprecher ausgegeben wird.

12. Elektronische Vorrichtung nach Anspruch 11, wobei das unhörbare Frequenzsignal einen Frequenzbereich von etwa 20 Hz oder weniger umfasst.

13. Elektronische Vorrichtung nach Anspruch 10, die ferner einen Verstärker umfasst, der mit dem Lautsprecher elektrisch verbunden ist.

14. Elektronische Vorrichtung nach Anspruch 10, die ferner ein wärmeabstrahlendes Element (511, 512) umfasst, das in einem Strahlungsraum angeordnet ist.

15. Elektronische Vorrichtung nach Anspruch 14, wobei das wärmeabstrahlende Element ein erstes wärmeabstrahlendes Element (511) mit einer Vielzahl von Vorsprüngen, ein zweites wärmeabstrahlendes Element (512), das ein Wärmerohr umfasst, und/oder ein drittes wärmeabstrahlendes Element umfasst, das eine Graphitschicht umfasst.

## Revendications

1. Dispositif électronique (100) comprenant :
un élément d'affichage (115) comprenant au moins un verre (113)
une monture (110) supportant au moins une portion de l'élément d'affichage; et
un élément de branche (120) couplé à au moins un côté de la monture,
où l'élément de branche comprend :
une première structure (210),
une deuxième structure (220) couplée à la première structure,
un haut-parleur (122) disposé dans un espace formé entre la première structure et la deuxième structure,
une carte de circuit imprimé (123) disposée dans l'espace formé entre la première structure et la deuxième structure, et
une nervure (250) comprise dans au moins l'une parmi la première structure ou la deuxième structure et logeant la carte de circuit imprimé,
où une surface arrière du haut-parleur est disposée pour faire face à un espace de résonance (RS2) formé entre la première structure et la deuxième structure, **caractérisé en ce que**
l'espace de résonance comprend un espace dans lequel la carte de circuit imprimé est disposée, et est connecté à au moins un trou de ventilation (230) formé dans au moins une région de la nervure, l'au moins un trou de ventilation connectant l'espace de résonance à un extérieur de l'élément de branche.

2. Dispositif électronique selon la revendication 1,
où une surface de la carte de circuit imprimé est disposée pour faire face à l'espace de résonance, et
où une autre surface de la carte de circuit imprimé est disposée pour faire face à un espace de rayonnement (RS1) séparé de l'espace de résonance.

3. Dispositif électronique selon la revendication 2,
où un premier composant électronique est disposé sur l'autre surface de la carte de circuit imprimé pour être connecté à l'espace de rayonnement, et
où un deuxième composant électronique consommant moins d'énergie que le premier composant électronique est disposé sur ladite une surface de la carte de circuit imprimé et connecté à l'espace de résonance.

4. Dispositif électronique selon la revendication 2, où au moins un parmi une plaque de rayonnement, un caloduc, un matériau d'interface thermique (TIM), ou une feuille de graphite est disposé dans l'espace de rayonnement.

5. Dispositif électronique selon la revendication 1, où la première structure ou la deuxième structure forme un espace connectant un trou de rayonnement sonore, qui est formé dans au moins l'une parmi la première structure ou la deuxième structure, à une surface avant du haut-parleur.

6. Dispositif électronique selon la revendication 1, comprenant en outre un élément imperméable configuré pour empêcher l'humidité d'être introduite dans le trou de ventilation, dans une région entourant un intérieur du trou de ventilation.

7. Dispositif électronique selon la revendication 1, comprenant en outre un élément d'étanchéité dans au moins une région de la nervure, l'élément d'étanchéité étant configuré pour loger le haut-parleur et la carte de circuit imprimé.

8. Dispositif électronique selon la revendication 7, où l'élément d'étanchéité (260) est en outre configuré dans une forme de courbe fermée le long d'une circonférence de la nervure logeant le haut-parleur et la carte de circuit imprimé.

9. Dispositif électronique selon la revendication 1, où l'au moins un trou de ventilation est disposé dans au moins une région d'une portion supérieure ou d'une portion inférieure de la nervure.

10. Dispositif électronique selon la revendication 1, comprenant en outre :
au moins un capteur de température disposé dans l'espace formé entre la première structure et la deuxième structure ; et
au moins un processeur (920) connecté électriquement au haut-parleur, à la carte de circuit imprimé, et à l'au moins un capteur de température,
où l'au moins un processeur est configuré pour :
mesurer une température de l'élément de branche à travers l'au moins un capteur de température,
déterminer si la température mesurée est égale ou supérieure à une première température,
lorsque la température mesurée est égale ou supérieure à la première température, déterminer si un signal sonore est émis par le haut-parleur, et
lorsque le signal sonore n'est pas émis par le haut-parleur, émettre le signal sonore par le haut-parleur.

11. Dispositif électronique selon la revendication 10, où, lorsque le signal sonore n'est pas émis par le haut-parleur, l'au moins un processeur est en outre configuré pour ajuster une intensité de volume du haut-parleur et pour émettre un signal de fréquence inaudible.

12. Dispositif électronique selon la revendication 11, où le signal de fréquence inaudible comprend un domaine de fréquence d'environ 20 Hz ou moins.

13. Dispositif électronique selon la revendication 10, comprenant en outre un amplificateur connecté électriquement au haut-parleur.

14. Dispositif électronique selon la revendication 10, comprenant en outre un élément de rayonnement de thermique (511, 512) disposé dans un espace de rayonnement.

15. Dispositif électronique selon la revendication 14, où l'élément de rayonnement thermique comprend au moins un parmi un premier élément de rayonnement thermique (511) ayant une pluralité de protubérances, un deuxième élément de rayonnement thermique (512) comprenant un caloduc, ou un troisième élément de rayonnement thermique comprenant une feuille de graphite.
